# FASCICULE DE BREVET EUROPEEN

(11) **EP 2 081 422 B1**
(45) Date de publication et mention de la délivrance du brevet: **07.03.2012**
(21) Numéro de dépôt: 08172822.2
(22) Date de dépôt: 23.12.2008
(51) Int. Cl.: H05K 7/20

(54) **Boîtier en profilés extrudés métalliques multi-positions pour la fabrication d'un dispositif électronique de puissance étanche**
Gehäuse aus stranggepressten Multipositions-Metallprofilen zur Herstellung einer dichten elektronischen Leistungsvorrichtung
Housing made of metallic extruded multiposition profils for manufactoring a waterproof eletronic power device

(30) Priorité: 16.01.2008 FR 0850255
(43) Date de publication de la demande: 22.07.2009
(73) Titulaire: Intelligent Electronic Systems (IES), F-34000 Montpellier (FR)
(72) Inventeur: Biagini, Eric, 34160 Saint Hilaire de Beauvoir (FR); Caussin, Yves, 13360 Roquevaire (FR)
(74) Mandataire: Domange, Maxime

(56) Documents cités:
- EP-A- 1 841 302
- WO-A-2007/041738
- DE-U1- 7 911 538
- US-A1- 2007 025 087

## Description

### Arrière-plan de l'invention

La présente invention se rapporte au domaine général des boîtiers en profilés extrudés métalliques destinés à la fabrication des dispositifs électroniques de puissance étanches.

De tels dispositifs de puissance étanches sont, par exemple, des chargeurs de batterie destinés à être embarqués sur des véhicules comme, par exemple, des élévateurs, des voitures de golf, etc, pouvant être nettoyés par des procédés relativement intrusifs, comme par exemple, un fluide sous pression. Dans ces applications, il est nécessaire que le chargeur de batterie soit totalement étanche de manière à protéger les composants électroniques qu'il comporte.

Dans le contexte particulier exposé ci-dessus, il n'est évidemment pas question d'utiliser une ventilation classique utilisant un ventilateur pulsant de l'air à l'intérieur du boîtier. En effet, l'ouverture nécessitée par l'action du ventilateur génère une entrée de fluide ou de particules solides non acceptable pour ce type de dispositif électronique de puissance.

Plus particulièrement, l'invention concerne un tel boîtier dont le profilé extrudé forme un tunnel de section fermée substantiellement rectangulaire muni d'ailettes sur au moins un coté du rectangle Ces ailettes, en augmentant la surface d'échange thermique du boitier avec l'air extérieur, permettent une dissipation de la chaleur. Cette dissipation est augmentée lorsque de l'air pulsé circule au contact de ces ailettes. Cependant, dans le contexte particulier exposé ci-dessus, il n'est également pas question de positionner un ventilateur pulsant de l'air sur les ailettes du boîtier. En effet, la technologie des ventilateurs ne permet pas de réaliser un tel ventilateur avec une étanchéité satisfaisante et fiable et tout cela à un coût raisonnable.

Généralement, un coté non muni d'ailettes est destiné à servir de base de fixation du boitier et de support pour des composants électroniques de puissance du dispositif électronique de puissance.

Le boîtier peut alors échanger des calories de façon marginale avec le support sur lequel il est fixé. Néanmoins, la nature de ce support n'est absolument pas connue a priori. Sa matière, son épaisseur ou sa surface peuvent présenter des caractéristiques thermiques très diverses qui permettront ou interdiront une évacuation de la chaleur.

Aussi, le boîtier étant fermé et ne pouvant être ventilé à l'extérieur, il doit donc échanger les calories produites avec l'air ambiant par les seuls modes de convection naturelle, c'est-à-dire sans ventilation artificielle, et de rayonnement.

Plus précisément encore, les ailettes du profilé extrudé formant le boîtier sont donc adaptées à la circulation de l'air par convection naturelle dans la direction d'extrusion à l'extérieur du boîtier.

En conséquence, il est nécessaire de prévoir que les modes de convection naturelle et de rayonnement soient maximaux de manière à assurer une évacuation de la chaleur suffisante pour un fonctionnement correct du dispositif électronique de puissance placé à l'intérieur du boîtier.

Par ailleurs, on sait que généralement les dispositifs électroniques de puissance sont produits en grande série et requièrent un prix de revient très encadré.

Concernant les paramètres de coût et concernant la réalisation de l'étanchéité, on sait que l'utilisation d'un élément extrudé d'un seul bloc en tunnel est particulièrement intéressante puisque cela assure l'étanchéité sur quatre côtés du boîtier. Cela facilite également le montage du chargeur de batterie ou, plus généralement du dispositif de puissance et donc contribue à diminuer le cout final du dispositif électronique de puissance.

L'extrusion d'un tunnel en aluminium implique, dans le cas d'un dissipateur de chaleur, que les ailettes soient dans le sens de l'extrusion. Aussi, les boîtiers existants actuellement en profilés extrudés comportent des ailettes dans la direction d'extrusion et permettent donc l'évacuation de la chaleur produite à l'intérieur du boîtier par le dispositif électronique de puissance à l'aide des ailettes, dès lors que celles-ci sont positionnées de manière à être verticales.

Il est par ailleurs connu que les performances thermiques s'améliorent non seulement avec la surface de contact avec l'air, d'où l'utilité des ailettes, mais aussi avec la vitesse de l'air sur cette surface. L'échauffement de l'air au contact des ailettes crée un mouvement naturel de l'air vers le haut qui est favorisé si l'air peut s'élever librement et donc si l'orientation des ailettes est verticale.

Le montage du boîtier sur une paroi verticale avec une orientation également verticale des ailettes donne donc une dissipation optimale pour un boîtier extrudé. Cela oblige alors que l'installation du dispositif de puissance soit prévue de la sorte dans tous les véhicules où le dispositif électronique de puissance devra être installé.

Cela est aujourd'hui une contrainte pénalisante qui freine l'extension de l'utilisation de dispositifs de puissance réalisés à l'aide d'un boitier extrudé. Des contextes très divers sont donc privés de cette solution à ce jour.

En revanche, pour un montage sur une paroi horizontale, le plan des ailettes est alors lui aussi horizontal et la convection de l'air est beaucoup plus faible. On observe malgré l'existence du rayonnement, une baisse d'efficacité très importante supérieure à 30 %.

Aussi, il existe des solutions assemblées où des radiateurs portant des ailettes sont assemblés sur un tunnel pré-extrudé dépourvu d'ailettes. Cela permet que la direction des ailettes soit perpendiculaire à la direction d'extrusion ou fasse un angle avec celle-ci. Les radiateurs utilisés présentent des profilés en peigne standards disposant généralement d'ailettes longues montées sur une base épaisse et destinées à la convection forcée. La convection forcée nécessite effectivement une densité supérieure du flux de calorie et donc une épaisseur plus importante de la base des ailettes. Elles aboutissent généralement à des boitiers ayant une masse d'aluminium ou de métal très importante ce qui est pénalisant. En outre, ces solutions sont complexes à fabriquer en usinage et en assemblage puisque la contrainte d'étanchéité est toujours présente.

Le document US 2007/0025 087 montre un example de boitier selon l'art antérieur.

### Objet et résumé de la présente invention

La présente invention a donc pour but principal de palier les inconvénients rencontrés avec les boîtiers connus de l'art antérieur et également de répondre aux exigences des contraintes de production connues pour ce genre de boîtier en proposant un boitier tel qu'exposé ci-dessus sur lequel les ailettes sont usinées transversalement à la direction d'extrusion pour former des créneaux dans les ailettes, ces créneaux étant alignés les uns à la suite des autres dans une direction, dite optimale, faisant un angle avec la direction d'extrusion optimisé en fonction d'une direction d'installation préférentielle prédéterminée et ces créneaux étant d'une géométrie telle qu'ils autorisent, à l'extérieur du boitier, la circulation de l'air par convection naturelle dans la direction optimale.

Avec un tel boîtier, il est possible de réaliser un dispositif électronique de puissance pouvant être installé dans plusieurs positions tout en assurant que la convection naturelle de l'air assurera une dissipation correcte de la chaleur.

La fabrication du boîtier par extrusion du tunnel permet de munir le tunnel d'ailettes dans le sens de l'extrusion. Ces ailettes, lorsqu'elles sont installées verticalement, permettent que l'échauffement de l'air à leur contact crée un mouvement naturel de l'air vers le haut favorisé par la position verticale des ailettes.

Lorsque le dispositif électronique de puissance est placé le long d'une autre direction d'installation que la direction verticale, les ailettes se retrouvent également dans cette direction. Grâce à l'invention, les ouvertures constituées par les créneaux préférentiellement alignés dans la direction verticale lorsque le boitier est placé dans la direction d'installation préférentielle permettent le maintien d'une convection naturelle de l'air.

La direction d'alignement des créneaux sur le boitier, dite direction optimale, est donc choisie selon l'invention en fonction de la direction d'installation préférentielle du boitier, prévue lors de la conception du dispositif électronique. La direction optimale sera ainsi idéalement verticale lorsque le boitier sera placé le long de la direction d'installation prévue. Avec l'invention, on autorise ainsi au moins deux directions préférentielles d'installation du boitier. En réalité, le boitier tolère des directions d'installation de part de d'autre de la direction d'installation préférentielle où l'évacuation de la chaleur grâce aux créneaux est tout à fait correcte. Les créneaux sont alors légèrement inclinés par rapport à la verticale mais procure malgré cela une convection correcte. L'invention autorise donc en réalité une installation du boitier dans plus de deux directions.

Le boîtier selon l'invention est réalisé à partir d'une quantité limitée de matière, ce qui permet de diminuer les coûts, la manipulation, le transport et l'énergie associée. La structure en tunnel extrudé permet une fabrication très simple d'un boitier selon l'invention en combinaison avec l'utilisation d'opérations d'usinage simples suivies d'opérations d'assemblage simples des différents constituants.

Avantageusement, au moins deux cotés opposés du rectangle sont munis d'ailettes usinées transversalement pour former des créneaux alignés les uns à la suite des autres dans des directions optimales identiques sur les deux côtés muni d'ailettes.

Cette caractéristique assure une évacuation de la chaleur correcte sur deux cotés opposés de la structure de section rectangulaire formant le boitier.

Selon une caractéristique originale de l'invention, au moins deux cotés opposés du rectangle sont munis d'ailettes usinées transversalement pour former des créneaux alignés les uns à la suite des autres dans des directions optimales différentes sur les deux côtés muni d'ailettes.

Munir deux cotés opposés d'ailettes usinées en créneaux selon deux directions différentes ne permet pas de maximiser l'évacuation de chaleur pour une direction d'installation donnée mais offre, en revanche, une plus grande latitude de placement directionnel du boitier selon l'invention, l'évacuation de la chaleur pouvant être majoritaire d'un coté pour certaines directions d'installation et majoritaires de l'autre coté pour d'autres directions d'installation.

Selon une caractéristique avantageuse, la (ou les) direction(s) optimale(s) fait(font) un angle compris entre 45 et 90° en valeur absolue inclus avec la direction d'extrusion.

Cela correspond aux directions d'installation généralement observées. En deçà de 45°, l'évacuation de la chaleur est assurée par une convection naturelle de l'air le long des ailettes.

Dans un mode de réalisation préférentiel, les créneaux sont alignés dans une direction perpendiculaire à la direction d'extrusion.

Cela permet de nombreux angles d'installation du boitier. En effet, pour une installation du boitier présentant des créneaux perpendiculaires entre 0 et 45°, les ailettes sont actives et évacuent efficacement la chaleur. Au-delà, l'invention autorise une convection naturelle au travers des créneaux, avec un maximum de cette convection pour une direction d'installation horizontale du boitier, direction dans laquelle les ailettes sont également horizontales mais les créneaux alignés dans la direction verticale.

En conséquence, cette caractéristique permet l'évacuation de la chaleur préférentiellement lorsque le boitier est installé verticalement ou horizontalement mais autorise également une évacuation correcte pour les directions d'installation intermédiaires.

Dans des modes de réalisation avantageux de l'invention, des créneaux sont réalisés à intervalles réguliers de 4 à 10 mm.

Une telle caractéristique assure que l'air puisse circuler par convection naturelle au travers de ces créneaux.

Dans des modes de réalisation avantageux de l'invention, les créneaux présentent des largeurs identiques comprises entre 4 et 10 mm.

Cette caractéristique assure que les créneaux n'offrent pas une résistance trop importante à l'air qui circule par convection naturelle et assurent par ailleurs une surface de contact des ailettes avec l'air encore assez important pour assurer une évacuation correcte de la chaleur lorsque le boîtier est positionné en position verticale.

Selon une caractéristique particulière de l'invention, les distances séparant les créneaux sont sensiblement égales aux largeurs des créneaux.

Cette caractéristique permet en réalité d'optimiser à la fois la circulation de l'air par convection naturelle et la surface d'échange disponible pour le transfert thermique.

Avantageusement, les ailettes sont espacées entre elles d'une distance de 6 à 16 mm.

Une telle distance séparant les ailettes correspond à un mode de circulation de l'air par convection naturelle.

En réalité, les largeurs et les distances de séparation des créneaux et des ailettes interviennent dans la définition d'un angle maximal de direction d'installation. En effet la largeur d'un circuit libre vertical pour l'air entre les créneaux est plus ou moins grande en fonction de la coïncidence entre la direction d'installation préférentielle et la direction d'installation réelle. Le boitier selon l'invention est donc préférentiellement réalisé en cherchant un optimum entre l'aluminium enlevé et l'aluminium conservé pour les échanges de chaleur et un optimum entre l'angle d'usinage et l'intervalle de directions d'installation envisageables.

Aussi, avantageusement, l'angle d'usinage et les caractéristiques de l'usinage que sont la largeur des créneaux et l'espacement entre créneaux, est déterminé pour obtenir un optimum en fonction de la direction d'installation envisagée, de l'éventail des directions d'installation possibles et de la quantité de chaleur à évacuer.

Selon une caractéristique particulière de l'invention, le profilé extrudé est tel que les deux cotés munis d'ailettes présentent une épaisseur décroissante de la base de fixation et de support des composants électroniques vers le coté du rectangle opposé à cette base.

Une telle caractéristique permet une évacuation optimale de la chaleur qui est communiquée par les composants électroniques directement sur la base de fixation du boîtier. L'épaisseur d'abord importante puis moins importante présente sous les ailettes, permet une meilleure conduction de la chaleur au plus près de la source de chaleur. Ces propriétés de conduction sont ensuite amenées à diminuer plus on s'éloigne de la base de fixation qui constitue la source de chaleur.

En effet, la largeur importante des cotés munis d'ailettes au niveau de la base de fixation et de support permet une conduction thermique accrue à ce niveau là où elle est la plus utile. Cette caractéristique permet donc d'optimiser le profil du boitier en vue d'une évacuation optimale de la chaleur produit au niveau de la base de fixation et de support.

Avantageusement, le coté servant de base de fixation du boitier et de support pour des composants électroniques présente une épaisseur plus importante que celle du coté opposé à cette base.

Ici encore, il s'agit de favoriser la conduction de la chaleur à l'endroit où elle est le plus présente, à savoir un endroit où sont placés les composants électroniques. On optimise ici le phénomène de conduction tout en ne nuisant pas à la masse totale du boitier.

Selon une caractéristique avantageuse de l'invention, le profilé extrudé est tel que, sur au moins un des cotés du rectangle, la paroi interne est pourvue de micro-stries ou de milli-ailettes.

Cette caractéristique permet d'augmenter encore la surface d'échange thermique avec l'air extérieur. Cette caractéristique, qui apporte un accroissement sensible de la dissipation de chaleur, est réalisable en fonction des contraintes de l'extrusion.

Selon une caractéristique avantageuse, le boîtier est traité par anodisation.

Cette caractéristique, qui permet de noircir le boîtier, assure une augmentation du rayonnement de celui-ci, lui permettant d'offrir une évacuation de la chaleur accrue.

Enfin, l'invention concerne un dispositif électronique de puissance multi-positions comprenant au moins un module électronique pour réaliser les fonctions du module électronique de puissance monté sur au moins une carte électronique placée au sein d'un boitier selon l'invention, ledit boitier étant fermé de manière étanche par deux flasques latérales fixées hermétiquement au boitier en profilé extrudé. Ces flasques permettent en outre d'implémenter les entrées et sorties-nécessaires au fonctionnement du dispositif.

Dans une application avantageuse, ce dispositif est un chargeur de batterie, au moins un module électronique est apte à mettre en oeuvre des fonctions de charge de batterie.

Avantageusement, le dispositif électronique de puissance inclut un système d'agitation d'air interne.

La combinaison entre un boîtier en profilé extrudé selon l'invention avec un système d'agitation d'air interne permet d'optimiser l'utilisation de la dissipation de la chaleur offerte par les ailettes formées sur le boîtier. En effet, le système d'agitation d'air interne est alors utilisé pour mettre l'air interne en contact avec les parois du boîtier. Des phénomènes convectifs se produisent alors favorisant l'absorption de la chaleur par les parois du boîtier.

Avantageusement, la carte électronique est portée par un support métallique destiné à être mis au contact d'au moins une paroi du boîtier.

### Brève description des dessins

D'autres caractéristiques et avantages de la présente invention ressortiront de la description faite ci-dessous, en référence aux dessins annexés qui en illustrent un exemple de réalisation dépourvu de tout caractère limitatif. Sur les figures :
La figure 1 est une vue en perspective d'un boîtier selon un mode de réalisation préférentiel de l'invention ;
Les figures 2A, 2B et 2C sont des vues, respectivement, de face, de détail et de dessous du boîtier représenté sur la figure 1 ;
Les figures 3A à 3D représentent un chargeur embarqué selon l'invention ;
Les figures 4A et 4B illustrent un mode de réalisation préférentiel d'un dispositif électronique de puissance selon l'invention ;
Les figures 5A et 5B représentent respectivement une vue de face et une vue de détail d'un mode de réalisation particulier de l'invention ;
Les figures 6A et 6B illustrent diverses caractéristiques particulières de l'invention ; et
La figure 7 expose schématiquement les principes de l'invention.

### Description détaillée d'un mode de réalisation

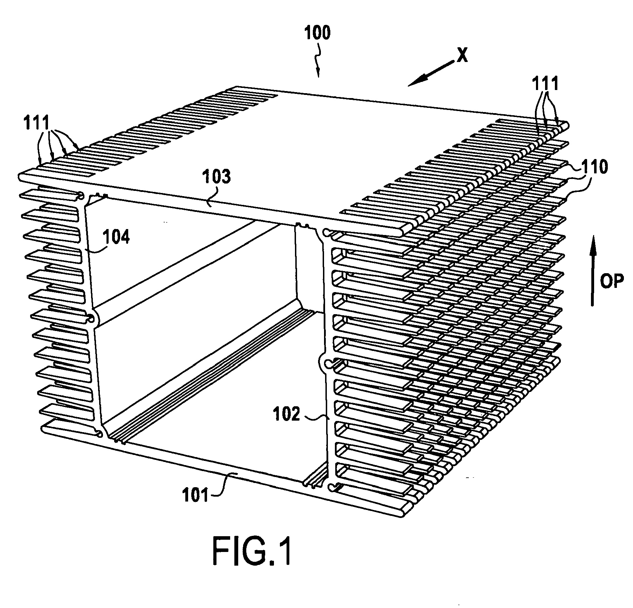

La figure 1 représente un boitier 100 selon l'invention dans un mode de réalisation préférentiel. Le boitier 100 est un profilé extrudé en tunnel selon la direction X.

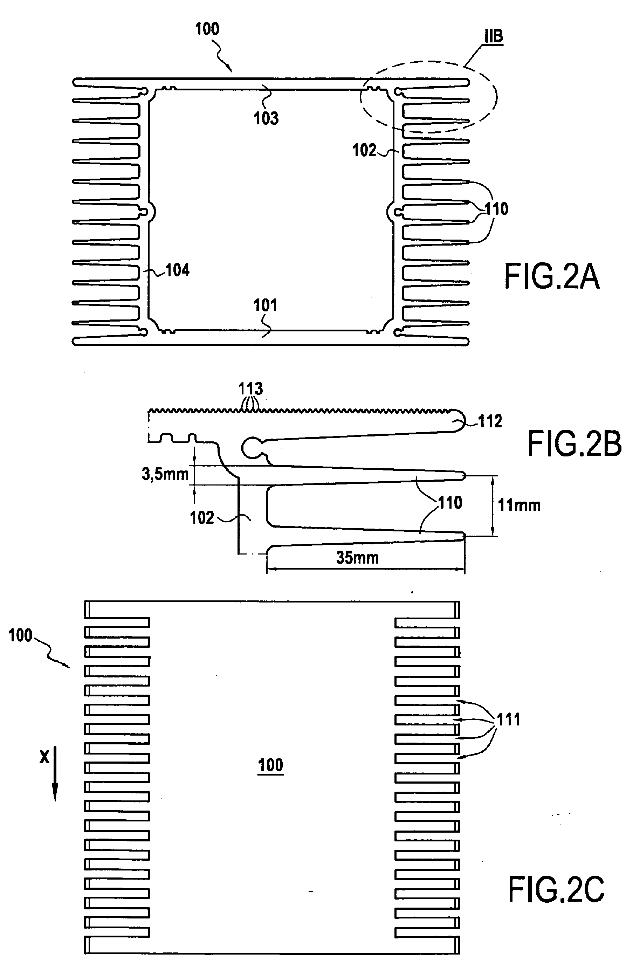

Ainsi que représenté sur la figure 2A, le profil d'extrusion est globalement rectangulaire, ici carré, et tel que le boîtier 100 porte latéralement des ailettes 110 sur deux côtés 102 et 104 du rectangle extrudé. On constate bien que le profil permet de ne réaliser des ailettes que dans la direction d'extrusion X.

Ces ailettes 110 extrudées s'étendent de manière parallèle entre une base 101 servant pour la fixation du boîtier et un quatrième côté 103 du rectangle formant le tunnel par extrusion. C'est dans ce contexte particulier que l'invention s'insère. Préférentiellement, on verra que la base 101 sert également pour le support d'éléments électroniques du dispositif électronique de puissance destiné à être porté par le boîtier 100.

Selon l'invention, les ailettes 110 sont usinées de manière à présenter des créneaux 111, alignés les uns à la suite des autres, dans une direction dite optimale OP. Ici, dans le mode de réalisation préférentiel de l'invention, la direction optimale OP est perpendiculaire à la direction d'extrusion X qui est également la direction des ailettes 110. La direction d'installation préférentielle est alors la direction horizontale.

Dans le cas où la direction optimale fait un angle différent de 90° avec la direction d'extrusion, la direction d'installation préférentielle est celle pour laquelle, lorsque le boitier 100 est placé dans cette direction, la direction optimale est verticale.

La figure 2 présente plus précisément les détails de constitution du boîtier 100 représenté sur la figure 1. Dans ce mode de réalisation, la densité d'ailettes 110 et de métal correspond aux besoins de la convection naturelle. La figure 2B présente un détail du profil du profilé extrudé du boîtier 100 tel que représenté sur la figure 2A. Ce détail montre que les ailettes 110 sont séparées entre elles d'une distance de 11 mm et présente une longueur de 35 mm à l'extérieur de la structure en tunnel constitué par les côtés 101, 102, 103 et 104. En outre, on voit, sur cette figure, que les ailettes 110 présentent une épaisseur de 3,5 mm et sont entourées par deux ailettes plus épaisses 112 prolongeant les côtés 101 et 103 du tunnel extrudé.

L'éloignement des ailettes ainsi que leur forme et leur dimension sont adaptées à une circulation de l'air par convection naturelle. Les ailettes 110 telles que présentées sur la figure 2 sont en effet considérées comme plutôt écartées les unes des autres, ce qui correspond à des caractéristiques permettant une bonne circulation de l'air par convection naturelle. En effet, les ailettes sont bien plus proches lorsqu'il s'agit de radiateurs fonctionnant en convection forcée et donc en combinaison avec de l'air pulsé.

Avantageusement, le côté 103 présente, sur sa face externe au boitier 100, une surface micro-striée par des stries 113 dont le rayon caractéristique est de l'ordre de quelques dixièmes de millimètres, 0,25 mm sur la figure 2B.

La figure 2C représente une vue de dessous du boîtier 100. On constate que, selon l'invention, les ailettes 110 ont été usinées de manière à ce qu'elles présentent des créneaux 111.

Dans le mode de réalisation préférentiel représenté ici, les créneaux 111 sont usinés de manière perpendiculaire à la direction X. Ils sont donc alignés les uns avec les autres dans la direction perpendiculaire à la direction X, c'est-à-dire dans la direction de visée de la figure 2C. L'alignement des créneaux 111 est également visible sur la figure 1.

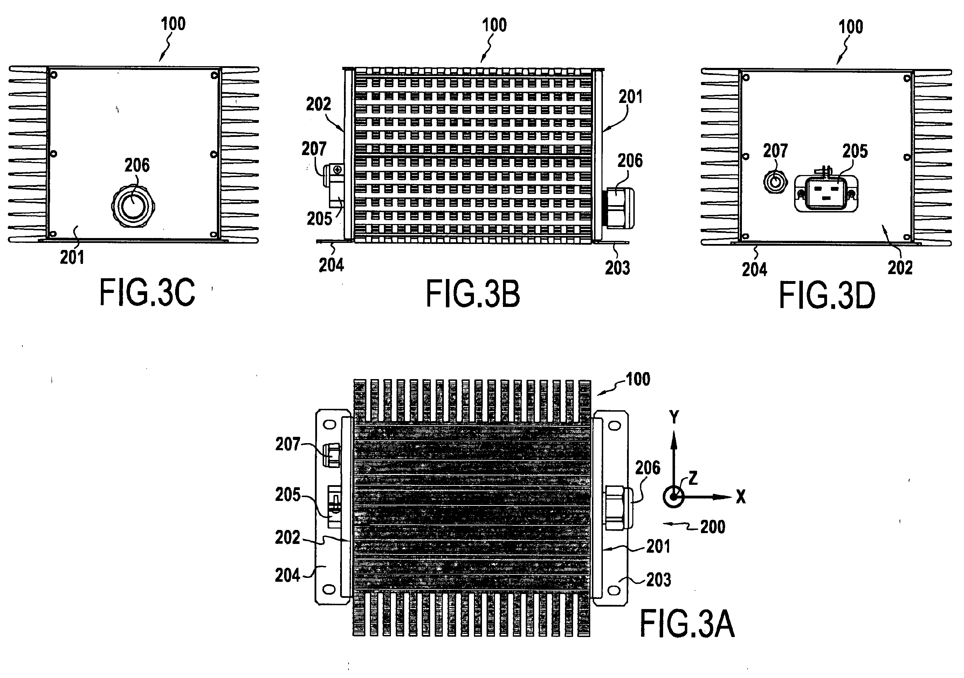

La figure 3 représente un chargeur embarqué 200 obtenu à l'aide d'un boîtier 100 tel que représenté sur la figure 1. Au sein de ce boitier, une quantité de chaleur telle est produite par le fonctionnement des composants électroniques du chargeur qu'il est absolument nécessaire d'évacuer sous peine de voir les composants électroniques se détériorer.

A l'intérieur du boîtier 100 est montée l'intégralité des composants électroniques nécessaires au fonctionnement du chargeur embarqué 200 avant que le boîtier 100 ne soit refermé par deux flasques 201 et 202. Au moins une des flasques, la flasque 202, porte un élément de connexion 205 permettant de connecter le chargeur de batterie embarqué 200 à des moyens d'alimentation non représentés. On constate que l'utilisation d'un boitier 100 extrudé en tunnel ensuite fermé par deux flasques 201 et 202 permet de garantir aisément l'étanchéité du chargeur embarqué 200 tout en assurant une grande facilité du montage.

Des moyens de branchement 206 et 207 d'une batterie non représentée sont avantageusement prévus sur chacune des flasques 201 et 202 du chargeur de batterie 200.

Avantageusement, chacune des flasques 201 et 202 comporte une partie destinée à la fixation du chargeur 200 sur un élément solidaire du véhicule dans lequel ce chargeur 200 est embarqué.

Des éléments de fixation 203 et 204 sont ainsi avantageusement d'une seule pièce avec les flasques 201 et 202. Ils portent des orifices aptes à recevoir des vis de fixation.

Les éléments de fixation 203 et 204 présentent avantageusement un léger décalage par rapport au niveau plan du coté 101 du boitier 100. Ce décalage permet d'assurer que le dessous du boîtier 100 soit effectivement au contact du support sur lequel est fixé le chargeur 200. Cela permet, autant que possible, que la chaleur se dissipe également grâce à une conduction entre le côté 101 du boitier 100 et le support sur lequel est fixé le chargeur 200.

La direction optimale selon laquelle ont été usinées les ailettes et selon laquelle les créneaux sont alignés est ici la direction Z sur le repère de la figure 2 où la direction X est la direction d'extrusion. Grâce à la présence des ailettes dans lesquelles les créneaux ont été usinés, le chargeur embarqué 200 présenté sur la figure 3 peut être installé en fixant les parties de fixation 203 et 204 à n'importe quel support plan du véhicule dans lequel ce chargeur est embarqué. Le support plan est, en effet, préférentiellement horizontal ou vertical mais peut aussi présenter un angle quelconque entre 0 et 90 degrés.

L'évacuation de la chaleur grâce à la convection naturelle de l'air entre les ailettes et dans les créneaux, permet une dissipation de la chaleur convenable pour de nombreuses orientations selon laquelle est installé le chargeur embarqué 200. L'évacuation sera néanmoins optimale pour une direction d'installation telle que, soit les ailettes sont verticales, soit la direction optimale est verticale.

On remarque qu'en ajoutant des ailettes usinées transversalement sur le troisième coté du boitier, celui opposé à la base 101, il devient aussi possible d'installer le boitier sur un support vertical, la direction d'extrusion étant horizontale ou faisant un angle non nul avec la verticale. Avec un troisième coté muni d'ailettes usinées perpendiculairement, le boitier peut, en pratique être installé dans n'importe quelle orientation.

Lorsque le boitier est en position verticale, on pourrait supposer que le boîtier selon l'invention présente une dissipation d'énergie moindre par rapport au boîtier dans lequel aucun créneau n'aurait été usiné dans les ailettes 110.

Il se trouve que, dans le cas de l'invention visant l'utilisation d'une convection naturelle uniquement, la dissipation d'énergie est toujours malgré tout meilleure avec les créneaux 111 que sans les créneaux 111, y compris dans la position où les ailettes 110 sont verticales. En effet, la présence de turbulences en convection naturelle permet d'obtenir un rendement de dissipation d'énergie meilleure en position verticale, alors même que du métal a été supprimé.

Ainsi qu'illustré sur la figure 3A, le boîtier est avantageusement anodisé de manière à présenter une surface noire qui rayonne donc davantage qu'une surface non anodisée.

Avantageusement, le chargeur 200 présente en outre une structure interne permettant encore d'améliorer la dissipation de chaleur grâce aux ailettes.

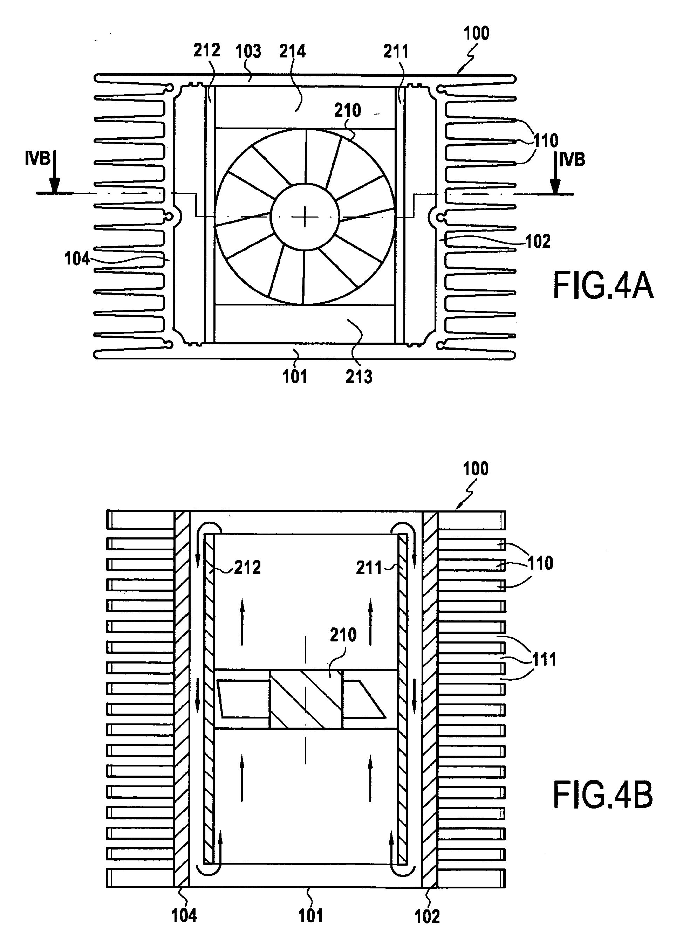

Les figures 4A et 4B sont des vues coupées schématiques, respectivement de face et de dessus, d'une réalisation particulière du chargeur 200 représenté sur la figure 3.

Selon cette réalisation, les éléments électroniques nécessaires au fonctionnement du chargeur sont portés par deux cartes électroniques 211 et 212. Entre ces deux cartes 211 et 212, est placé un ventilateur 210 apte à faire circuler l'air interne au boîtier 100 de la manière représentée par des flèches sur la figure 4B.

Afin que l'air ainsi pulsé circule bien entre les cartes 211 et 212 et les côtés 102 et 104, des cloisons 213 et 214, représentées sur la figure 4A, ferment les espaces entre le boîtier 100, le ventilateur 210 et les deux cartes 211 et 212, en haut et en bas du ventilateur 210. La circulation de l'air est ainsi forcée.

Cette réalisation est présentée pour un chargeur réalisé avec deux cartes électroniques placées latéralement dans le boîtier 100. D'autres réalisations de chargeur ou de dispositif électronique de puissance sont néanmoins tout à fait envisageables avec le boîtier 100 selon l'invention. Notamment on pense à des réalisations dans lesquelles une carte portant les composants électroniques de puissance serait placée en contact ou à proximité de la base 101 du boîtier 100 qui servirait de capteur de chaleur et de conducteur de chaleur vers les cotés 102 et 104 portant les ailettes 110.

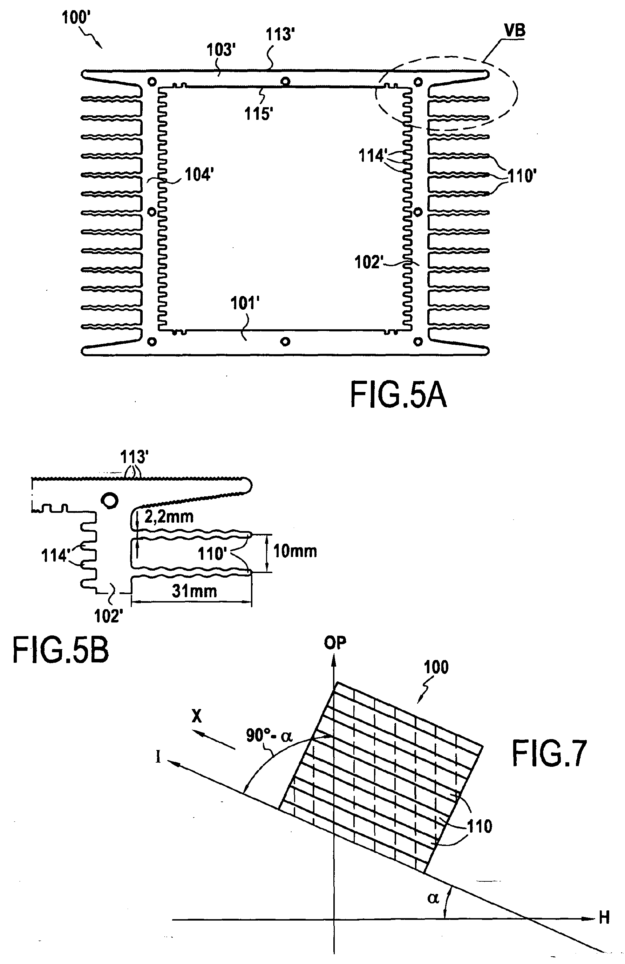

La figure 5 présente un certain nombre de caractéristiques annexes pour un boîtier 100' selon l'invention. Sur les figures 5A et 5B, le profil d'extrusion présente un profil d'ailettes 110' ondulées. Cette ondulation permet d'augmenter la surface d'échange entre les ailettes 110' et l'air qui circule entre ces ailettes 110'.

On constate en outre, sur la figure 5B, que l'épaisseur des ailettes 110' est plus faible que celle des ailettes 110 présentées sur le mode de réalisation de la figure 1. Ces ailettes 110' présentent effectivement une largeur de 2,2 mm et sont séparées de 10 mm. En effet, puisque les boitiers selon l'invention fonctionnent en convection naturelle, chaque ailette n'a pas une très grosse charge thermique à assurer. Aussi, les ailettes 110' sont avantageusement hautes et étroites.

Ici encore, ces caractéristiques permettent d'adapter le boîtier 110' aux conditions spécifiques de la convection naturelle qui permet une évacuation d'autant meilleure de la chaleur que l'air peut aisément circuler entre les ailettes 110' et que la surface d'échange est augmentée. Le fait que les ailettes 110' soient moins épaisses permet d'augmenter l'espace de circulation de l'air, ce qui est un paramètre majeur en convection naturelle.

Le profil d'extrusion représenté sur la figure 5A présente également des petites ailettes internes au boîtier 100' séparées les unes des autres de 5 mm et présentant une épaisseur de 2,2 mm.

Ces ailettes permettent d'augmenter la surface d'échange à l'intérieur du boîtier 100' et donc de favoriser la conduction de la chaleur vers l'extérieur du boîtier 100'.

On constate encore que ce boîtier 100' est muni de micro-stries 115' à l'intérieur sur le côté 103' en plus de micro-stries 113' à l'extérieur du boitier 100'. Cette caractéristique vise de nouveau à augmenter la surface d'échange entre l'air interne ou externe et le boîtier 100'.

Enfin, le coté 101' est plus épais que le coté 101 du boîtier 100 de la figure 2 pour assurer une conduction de la chaleur vers les cotés 102' et 104' portant les ailettes 110'. Cette caractéristique est particulièrement avantageuse lorsqu'une carte électronique portant des composants électroniques de puissance est placée à proximité ou au contact du coté 101' et évacue de la chaleur par conduction dans le boitier 101' par ce contact ou cette proximité.

Par ailleurs, l'utilisation du côté 101 pour placer les composants électroniques et éventuellement pour placer une carte les supportant est pratiquement très intéressante puisque cela évite des problèmes de fixation sur les côtés latéraux où sont placées les ailettes. En effet, il est difficile de placer des vis ou des éléments de fixation au milieu des ailettes puisqu'elles génèrent un encombrement non négligeable et une gêne pour la mise en place des vis et le vissage.

En outre, lorsque les éléments électroniques ou une carte électronique sont fixés sur le coté 101 et que des vis traversent donc le coté 101, la fixation ultérieure du chargeur 200 sur un support plan permet d'assurer une bonne étanchéité au niveau de la base 101 même si celle-ci a été percée pour laisser passer les vis.

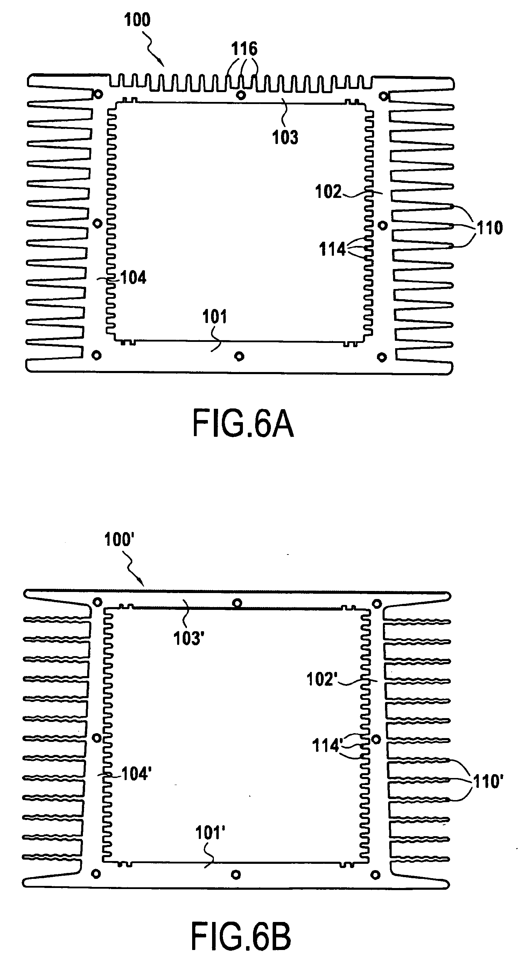

Les figures 6A et 6B montrent deux modes de réalisation s'inspirant des modes de réalisation des figures 1 et 5. Les caractéristiques de ces modes de réalisation améliorent globalement le rendement de dissipation d'énergie du boîtier 100 ou 100'.

Selon ces figures 6A et 6B, les côtés 102 ou 102' et 104 ou 104' présentent une épaisseur allant en s'amenuisant entre la base 101 ou 101' et le haut du boîtier 103 ou 103'. Cette caractéristique permet d'évacuer de manière optimale la chaleur fournie au côté 101' le long des côtés 102' et 104'. Cette caractéristique est donc particulièrement intéressante dans le cas où la base 101 sert de support pour une carte électronique comprenant des composants électroniques de puissance.

La diminution d'épaisseur des côtés 102 ou 102' et 104 ou 104' réside en une optimisation de la dissipation d'énergie tout en ne compromettant pas la maniabilité du chargeur, c'est-à-dire en n'augmentant pas de manière dissuasive la masse totale du boîtier 100 ou 100'.

Avec un tel profil des côtés 102 ou 102' et 104 ou 104', on autorise en effet que les ailettes 110 ou 110' les plus basses, donc les plus proches du côté 101 ou 101', évacuent plus de chaleur que les ailettes 110 ou 110' les plus élevées, c'est-à-dire celles proches du côté supérieur 103 ou 103'.

Plus précisément, on constate qu'un différentiel de température moins important entre le haut et le bas d'un boîtier 100 ou 100' selon les réalisations des figures 6A ou 6B est observé par rapport au différentiel de température observé pour un boitier 100 ou 100' selon les réalisations des figures 2 ou 5 présentant une épaisseur constante des cotés 102 ou 102' et 104 et 104'. La dissipation étant proportionnelle à l'écart de température entre l'air extérieur et la température du boîtier, la dissipation d'énergie est donc mieux répartie lorsque le profil extrudé présente les caractéristiques de la figure 6.

Plus on se rapproche du côté 103, moins il est nécessaire que la résistance thermique soit faible.

Par conséquent, plus on s'éloigne de la base 101, moins le besoin de transfert thermique est important et donc moins il est nécessaire de permettre une conduction importante et moins le côté 102 ou 104 doit être épais.

Dans les modes de réalisation proposés sur les figures 6A et 6B, l'évacuation de la chaleur est encore améliorée grâce à la présence de petites ailettes 114 ou 114'.

En outre, sur la figure 6A, le côté supérieur 103 est avantageusement muni de petites ailettes 116 de hauteur différente. Cette caractéristique est une amélioration supplémentaire selon l'invention permettant une augmentation de l'évacuation de la chaleur également par la face supérieure 103 du boîtier 100. Dans certaines applications, un tel profilé extrudé portant des ailettes sur le coté 103 est utile. Les petites ailettes 116 peuvent, le cas échéant, être également usinées d'une manière similaire aux ailettes 110 et, ainsi, présenter des créneaux.

Ainsi, on peut envisager que des ailettes 116 plus longues, par exemple de la longueur des ailettes 110, soient prévues sur le coté 103 du profil d'extrusion du boîtier 100 de manière à munir le boîtier d'une troisième face comportant des ailettes, usinées ou non.

Les modes de réalisation présentés sont tous tels que les créneaux sont réalisés de manière perpendiculaire à la direction d'extrusion. Cette caractéristique permet en effet une très bonne compatibilité avec toutes les positions d'installation possibles du dispositif électronique de puissance fabriqué avec un boitier selon ce mode de réalisation de l'invention.

Néanmoins, comme défini selon les principes de l'invention, en présence d'applications dans lesquels le boitier sera dédié à être installé sur des supports faisant des angles avec l'horizontale inclus dans un certain intervalle connu d'avance, la direction optimale d'usinage des créneaux fera avantageusement un angle de 90°-l'angle moyen de cet intervalle avec la direction d'extrusion, cette caractéristique est illustrée sur la figure 7.

Sur cette figure qui résume les principes de l'invention, la direction d'installation I du boitier 100, confondue avec la direction d'extrusion X, fait un angle α avec l'horizontale H. Selon l'invention, la direction optimale OP fait alors un angle 90°-α avec la direction d'extrusion X. Les créneaux, non représentés mais dont les alignements sont schématisés par des segments pointillés sur la figure 7, sont alors usinés pour être alignés le long de la direction optimale OP. Ils sont alors alignés dans la direction verticale dès lors que le boitier 100 est installé le long de la direction d'installation I.

Cela permet d'assurer que les créneaux sont, selon l'invention, alignés les uns avec les autres le long d'une direction médiane qui sera sensiblement placée à la verticale lors du positionnement du dispositif électronique de puissance sur son support plan.

On remarque enfin que diverses mises en oeuvre peuvent être réalisées selon les principes de l'invention. Notamment, outre les caractéristiques et modes de réalisation présentés auparavant, le boîtier selon l'invention peut comporter des ailettes dissymétriques. Cette réalisation sera utile lorsqu'une carte électronique est placée à proximité d'un seul des deux côtés 102 ou 104 du boîtier selon l'invention, les ailettes les plus longues étant du côté où est placée cette carte.

## Revendications

1. Boitier (100) en profilé extrudé en alliage d'aluminium pour la fabrication d'un dispositif électronique de puissance étanche multi-positions (200), le profilé extrudé formant un tunnel de section fermée substantiellement rectangulaire muni d'ailettes (110) sur au moins un coté du rectangle, ces ailettes (110) autorisant, à l'extérieur du boitier (100), la circulation de l'air par convection naturelle dans la direction d'extrusion (X), un coté (101) non muni d'ailettes étant destiné à servir de base de fixation du boitier (100) et de support pour des composants électroniques de puissance du dispositif électronique de puissance (200), **caractérisé en ce que** les ailettes (110) sont usinées transversalement à la direction d'extrusion (X) pour former des créneaux (111) dans les ailettes (110), ces créneaux (111) étant alignés les uns à la suite des autres dans une direction, dite optimale (OP), faisant un angle avec la direction d'extrusion (X) optimisé en fonction d'une direction d'installation du boitier (100) préférentielle prédéterminée et ces créneaux (111) étant d'une géométrie telle qu'ils autorisent, à l'extérieur du boitier (100), la circulation de l'air par convection naturelle dans la direction optimale (OP).

2. Boitier (100) selon la revendication 1, **caractérisé en ce qu'**au moins deux cotés opposés (102, 104) du rectangle sont munis d'ailettes (110) usinées transversalement pour former des créneaux (111) alignés les uns à la suite des autres dans des directions optimales identiques sur les deux côtés (102, 104) munis d'ailettes (110).

3. Boitier (100) selon la revendication 1, **caractérisé en ce qu'**au moins deux cotés opposés (102, 104) du rectangle sont munis d'ailettes (110) usinées transversalement pour former des créneaux (111) alignés les uns à la suite des autres dans des directions optimales différentes sur les deux côtés (102, 104) muni d'ailettes.

4. Boitier (100) selon l'une des revendications 1 à 3, **caractérisé en ce que** la (ou les) direction(s) optimale(s) (OP) fait(font) un angle compris entre 45 et 90° en valeur absolue inclus avec la direction d'extrusion (X).

5. Boitier (100) en profilé extrudé métallique selon l'une des revendications précédentes, **caractérisé en ce que** les créneaux (111) sont alignés dans une direction (OP) perpendiculaire à la direction d'extrusion (X).

6. Boitier (100) en profilé extrudé métallique selon l'une des revendications précédentes, **caractérisé en ce que** les créneaux (111) sont réalisés à intervalles réguliers de 4 mm à 10 mm.

7. Boitier (100) en profilé extrudé métallique selon l'une des revendications précédentes, **caractérisé en ce que** les créneaux (111) présentent des largeurs identiques comprises entre 4 mm à 10 mm.

8. Boitier (100) en profilé extrudé métallique selon l'une des revendications précédentes, **caractérisé en ce que** les distances séparant les créneaux (111) sont sensiblement égales aux largeurs des créneaux (111).

9. Boitier (100) en profilé extrudé métallique selon l'une des revendications précédentes, **caractérisé en ce que** les ailettes (110) sont espacées entre elles d'une distance de 6 mm à 16 mm.

10. Boitier (100) en profilé extrudé métallique selon l'une des revendications précédentes, **caractérisé en ce que** le profilé extrudé est tel que le ou les coté(s) (102, 104) muni(s) d'ailettes (110) présente(nt) une épaisseur décroissante de la base (101) de fixation et de support des composants électroniques vers le coté (103) du rectangle opposé à cette base (101).

11. Boitier (100) en profilé extrudé métallique selon l'une des revendications précédentes, **caractérisé en ce que** le coté (101) servant de base de fixation du boitier et de support pour des composants électroniques présente une épaisseur plus importante que celle du coté (103) opposé à cette base (101).

12. Boitier (100) en profilé extrudé métallique selon l'une des revendications précédentes, **caractérisé en ce que** le profilé extrudé est tel que, sur au moins un des cotés du rectangle (103, 102, 104), la paroi interne est pourvue de micro-stries (115') ou de milli-ailettes (114').

13. Boitier (100) en profilé extrudé métallique selon l'une-des revendications précédentes, **caractérisé en ce que** le boitier (100) est traité par anodisation.

14. Dispositif électronique de puissance multi-positions (200) comprenant au moins un module électronique pour réaliser les fonctions du module électronique de puissance monté sur au moins une carte électronique (211, 212) placée au sein d'un boitier (100) selon les revendications précédentes 1 à 13, ledit boitier (100) étant fermé de manière étanche par deux flasques latérales (20, 202) fixées hermétiquement au boitier (100) en profilé extrudé.

15. Dispositif électronique de puissance multi-positions (200) selon la revendication 14, **caractérisé en ce que**, ce dispositif (200) étant un chargeur de batterie, au moins un module électronique est apte à mettre en oeuvre des fonctions de charge de batterie.

16. Dispositif électronique de puissance multi-positions (200) selon l'une des revendications 14 et 15, **caractérisé en ce qu'**il inclut un système d'agitation d'air interne (210).

17. Dispositif électronique de puissance multi-positions (200) selon l'une des revendications 14 à 16, **caractérisé en ce que** la carte électronique est portée par un support métallique destiné à être mis au contact d'au moins une paroi du boitier (100).

## Claims

1. A housing (100) made of aluminum alloy extruded section member for manufacturing a multi-position waterproof power electronic device (200), the extruded section member forming a tunnel that is of substantially rectangular closed section and that is provided with fins (110) on at least one side of the rectangle, said fins (110) allowing air to flow outside the housing (100) by natural convection in the extrusion direction (X), a side (101) that is not provided with fins being designed to serve as a base for fastening the housing (100) and as a support for power electronic components of the power electronic device (200), said housing being **characterized in that** the fins (110) are machined transversely to the extrusion direction (X) so as to form notches (111) in the fins (110), said notches (111) being aligned in succession in an "optimum" direction (OP) that forms an angle with the extrusion direction (X) that is optimized as a function of a predetermined preferred installation direction for installing the housing (100), and said notches (111) being of geometrical shape such that they allow air to flow outside the housing (100) by natural convection in the optimum direction (OP).

2. A housing (200) according to claim 1, **characterized in that** at least two opposite sides (102, 104) of the rectangle are provided with fins (110) that are machined transversely so as to form notches (111) that are aligned in succession in optimum directions that are identical on both of the sides (102, 104) provided with fins (110).

3. A housing (100) according to claim 1, **characterized in that** at least two opposite sides (102, 104) of the rectangle are provided with fins (110) that are machined transversely so as to form notches (111) aligned in succession in optimum directions that are different on each of the two sides (102, 104) provided with fins.

4. A housing (100) according to any one of claims 1 to 3, **characterized in that** the optimum direction(s) (OP) form(s) an angle lying in the range 45° to 90° in absolute terms with the extrusion direction (X).

5. A housing (100) made of metal extruded section member according to any preceding claim, **characterized in that** the notches (111) are aligned in a direction (OP) that is perpendicular to the extrusion direction (X).

6. A housing (100) made of metal extruded section member according to any preceding claim, **characterized in that** the notches (111) are formed at regular intervals lying in the range 4 mm to 10 mm.

7. A housing (100) made of metal extruded section member according to any preceding claim, **characterized in that** the notches (111) present identical widths lying in the range 4 mm to 10 mm.

8. A housing (100) made of metal extruded section member according to any preceding claim, **characterized in that** the distances between the notches (111) are substantially equal to the widths of the notches (111).

9. A housing (100) made of metal extruded section member according to any preceding claim, **characterized in that** the fins (110) are spaced apart by a distance lying in the range 6 mm to 16 mm.

10. A housing (100) made of metal extruded section member according to any preceding claim, **characterized in that** the extruded section member is such that the side(s) (102, 104) provided with fins (110) is/are of thickness that tapers going from the base (101) for fastening the housing and for supporting the electronic components towards the side (103) of the rectangle that is opposite from said base (101).

11. A housing (100) made of metal extruded section member according to any preceding claim, **characterized in that** the side (101) serving as a base for fastening the housing and as a support for the electronic components has a thickness that is greater than the thickness of the side (103) opposite from the base (101).

12. A housing (100) made of metal extruded section member according to any preceding claim, **characterized in that** the extruded section member is such that, on at least one of the sides of the rectangle (103, 102, 104), the inside wall is provided with micro-striations (115') or with micro-fins (114').

13. A housing (100) made of metal extruded section member according to any preceding claim, **characterized in that** the housing (100) is treated by anodization.

14. A multi-position power electronic device (200) comprising at least one electronic module for performing the functions of a power electronic module mounted on at least one electronic card (211, 212) placed inside a housing (100) according to the preceding claims 1 to 13, said housing (100) being closed in waterproof manner by two side cheek plates (20, 202) fastened hermetically to the housing (100) made of an extruded section member.

15. A multi-position power electronic device (200) according to claim 14, **characterized in that**, with said device (200) being a battery charger, at least one electronic module is suitable for implementing battery charging functions.

16. A multi-position power electronic device (200) according to claim 14 or 15, **characterized in that** it further includes an internal air flow system.

17. A multi-position power electronic device (200) according to any one of claims 14 to 16, **characterized in that** the electronic card is carried by a metal support designed to be put into contact with at least one wall of the housing (100).

## Patentansprüche

1. Gehäuse (100) aus stranggepreßtem Profil aus Aluminiumlegierung für die Herstellung einer dichten elektronischen Mehrstellungs-Leistungsvorrichtung (200), wobei das stranggepreßte Profil einen Tunnel mit geschlossenem, im wesentlichen rechteckigen Querschnitt bildet, der an wenigstens einer Seite des Rechtecks mit Rippen (110) versehen ist, wobei diese Rippen (110) außerhalb des Gehäuses (100) das Zirkulieren der Luft mittels natürlicher Konvektion in Strangpreßrichtung (X) zulassen, wobei eine nicht mit Rippen versehene Seite (101) dazu bestimmt ist, als Basis zum Befestigen des Gehäuses (100) und als Träger für elektronische Leistungsbauteile der elektronischen Leistungsvorrichtung (200) zu dienen, **dadurch gekennzeichnet, daß** die Rippen (110) quer zur Strangpreßrichtung (X) bearbeitet sind, um Lücken (111) in den Rippen (110) zu bilden, wobei diese Lücken (111) nacheinander in einer sogenannten optimalen Richtung (OP) ausgerichtet sind, die mit der Strangpreßrichtung (X) einen Winkel bildet, der in Abhängigkeit einer bevorzugten vorbestimmten Installationsrichtung des Gehäuses (100) optimiert ist, und wobei diese Lücken (111) eine derartige Geometrie aufweisen, daß sie außerhalb des Gehäuses (100) das Zirkulieren der Luft mittels natürlicher Konvektion in der optimalen Richtung (OP) zulassen.

2. Gehäuse (100) nach Anspruch 1, **dadurch gekennzeichnet, daß** wenigstens zwei gegenüberliegende Seiten (102, 104) des Rechtecks mit Rippen (110) versehen sind, die quer bearbeitet sind, um Lücken (111) zu bilden, welche nacheinander in optimalen Richtungen (OP) ausgerichtet sind, die an den beiden mit Rippen (110) versehenen Seiten (102, 104) identisch sind.

3. Gehäuse (100) nach Anspruch 1, **dadurch gekennzeichnet, daß** wenigstens zwei gegenüberliegende Seiten (102, 104) des Rechtecks mit Rippen (110) versehen sind, die quer bearbeitet sind, um Lücken (111) zu bilden, welche nacheinander in optimalen Richtungen (OP) ausgerichtet sind, die an den beiden mit Rippen versehenen Seiten (102, 104) unterschiedlich sind.

4. Gehäuse (100) nach einem der Ansprüche 1 bis 3, **dadurch gekennzeichnet, daß** die optimale(n) Richtung(en) (OP) einen mit der Strangpreßrichtung (X) eingeschlossenen Winkel im Bereich zwischen 45 und 90° als Absolutwert bildet (bilden).

5. Gehäuse (100) aus stranggepreßtem Metallprofil, nach einem der vorhergehenden Ansprüche, **dadurch gekennzeichnet, daß** die Lücken (111) in einer zu der Strangpreßrichtung (X) senkrechten Richtung (OP) ausgerichtet sind.

6. Gehäuse (100) aus stranggepreßtem Metallprofil, nach einem der vorhergehenden Ansprüche, **dadurch gekennzeichnet, daß** die Lücken (111) in gleichmäßigen Abständen von 4 mm bis 10 mm ausgebildet sind.

7. Gehäuse (100) aus stranggepreßtem Metallprofil, nach einem der vorhergehenden Ansprüche, **dadurch gekennzeichnet, daß** die Lücken (111) gleiche Breiten im Bereich zwischen 4 mm und 10 mm aufweisen.

8. Gehäuse (100) aus stranggepreßtem Metallprofil, nach einem der vorhergehenden Ansprüche, **dadurch gekennzeichnet, daß** die Abstände zwischen den Lücken (111) im wesentlichen gleich den Breiten der Lücken (111) sind.

9. Gehäuse (100) aus stranggepreßtem Metallprofil, nach einem der vorhergehenden Ansprüche, **dadurch gekennzeichnet, daß** die Rippen (110) um einen Abstand von 6 mm bis 16 mm voneinander beabstandet sind.

10. Gehäuse (100) aus stranggepreßtem Metallprofil, nach einem der vorhergehenden Ansprüche, **dadurch gekennzeichnet, daß** das stranggepreßte Profil derart ist, daß die mit Rippen (110) versehene(n) Seite oder Seiten (102, 104) eine Dicke aufweisen, die von der Basis (101) zum Befestigen und zum Tragen der elektronischen Bauteile in Richtung der dieser Basis (101) gegenüberliegenden Seite (103) des Rechtecks abnehmend ist.

11. Gehäuse (100) aus stranggepreßtem Metallprofil, nach einem der vorhergehenden Ansprüche, **dadurch gekennzeichnet, daß** die Seite (101), die als Basis zum Befestigen des Gehäuses und als Träger für elektronische Bauteile dient, eine größere Dicke als die dieser Basis (101) gegenüberliegende Seite (103) aufweist.

12. Gehäuse (100) aus stranggepreßtem Metallprofil, nach einem der vorhergehenden Ansprüche, **dadurch gekennzeichnet, daß** das Strangpreßprofil derart ist, daß an wenigstens einer der Seiten des Rechtecks (103, 102, 104) die Innenwand mit Mikrorillen (115') oder mit Millirippen (114') versehen ist.

13. Gehäuse (100) aus stranggepreßtem Metallprofil, nach einem der vorhergehenden Ansprüche, **dadurch gekennzeichnet, daß** das Gehäuse (100) mittels Anodisieren behandelt ist.

14. Elektronische Mehrstellungs-Leistungsvorrichtung (200) mit wenigstens einem elektronischen Modul zum Ausführen der Funktionen des elektronischen Leistungsmoduls, das auf wenigstens einer Elektronikkarte (211, 212) angebracht ist, die innerhalb eines Gehäuses (100) nach den vorstehenden Ansprüchen 1 bis 13 angeordnet ist, wobei das Gehäuse (100) durch zwei Seitenflansche (20, 202), die an dem Gehäuse (100) aus Strangpreßprofil hermetisch befestigt sind, dicht verschlossen ist.

15. Elektronische Mehrstellungs-Leistungsvorrichtung (200) nach Anspruch 14, **dadurch gekennzeichnet, daß** - wenn diese Vorrichtung (200) ein Batterieladegerät ist
- wenigstens ein elektronisches Modul geeignet ist, Batterieladefunktionen auszuführen.

16. Elektronische Mehrstellungs-Leistungsvorrichtung (200) nach einem der Ansprüche 14 und 15, **dadurch gekennzeichnet, daß** sie ein internes Luftbewegungssystem (210) einschließt.

17. Elektronische Mehrstellungs-Leistungsvorrichtung (200) nach einem der Ansprüche 14 bis 16, **dadurch gekennzeichnet, daß** die Elektronikkarte von einem Metallträger getragen ist, welcher dazu bestimmt ist, mit wenigstens einer Wand des Gehäuses (100) in Kontakt gebracht zu werden.
